# FASCICULE DE BREVET EUROPEEN

(11) **EP 4 526 919 B1**
(45) Date de publication et mention de la délivrance du brevet: **16.09.2026**
(21) Numéro de dépôt: 23723208.7
(22) Date de dépôt: 04.05.2023
(51) Int. Cl.: H10P 90/00, H10P 10/00

(54) **PROCÉDÉ DE TRANSFERT D'UNE COUCHE DEPUIS UN SUBSTRAT SOURCE VERS UN SUBSTRAT DESTINATION**
VERFAHREN ZUM ÜBERTRAGEN EINER SCHICHT VON EINEM QUELLSUBSTRAT AUF EIN ZIELSUBSTRAT
METHOD FOR TRANSFERRING A LAYER FROM A SOURCE SUBSTRATE TO A DESTINATION SUBSTRATE

(30) Priorité: 18.05.2022 FR 2204713
(43) Date de publication de la demande: 26.03.2025
(73) Titulaire: Commissariat à l'Energie Atomique et aux Energies Alternatives, 75015 Paris (FR)
(72) Inventeur: WIDIEZ, Julie, 38054 GRENOBLE CEDEX 09 (FR); FOURNEL, Frank, 38054 GRENOBLE CEDEX 09 (FR)
(74) Mandataire: Cabinet Beaumont
(86) Numéro de dépôt international: PCT/EP2023/061790
(87) Numéro de publication internationale: WO 2023/222398

(56) Documents cités:
- US-A1- 2007 023 867
- US-B2- 6 908 832

## Description

La présente demande est basée sur, et revendique la priorité de, la demande de brevet français 2204713 déposée le 18 mai 2022 et ayant pour titre "Procédé de transfert d'une couche depuis un substrat source vers un substrat destination"

### Domaine technique

La présente description concerne de façon générale les procédés de fabrication de composants microélectroniques à base de matériaux semiconducteurs. Elle vise plus particulièrement un procédé de transfert d'une couche semiconductrice depuis un substrat source vers un substrat destination.

### Technique antérieure

Dans les procédés de fabrication de composants microélectroniques, des transferts de couches sont couramment utilisés pour reporter une couche semiconductrice relativement mince et de haute qualité cristalline, sur un substrat destination plus épais et de qualité cristalline inférieure ou en un matériau moins onéreux.

Après le transfert, la couche reportée peut servir de base à une étape d'épitaxie. Des composants microélectroniques peuvent ensuite être formés dans et sur la couche épitaxiée.

Il serait souhaitable de pallier au moins en partie certains inconvénients des procédés connus de transfert d'une couche semiconductrice d'un substrat source vers un substrat destination. Le document US 2007/023867 décrit un procédé de transfert d'une couche depuis un substrat source vers un substrat destination , comprenant les étapes suivantes : Former une marche en vis à vis d'une partie périphérique de la surface de collage de ladite couche et/ou du substrat de destination , cette opération impliquant une gravure mécanique ou chimique; activer la surface de collage de ladite couche et la surface de collage du substrat destination par gravure ionique et dépôt ionique d'un matériau de collage ; et mettre en contact la surface de collage de ladite couche avec la surface de collage du substrat destination.

On s'intéresse ici plus particulièrement à l'amélioration de la qualité des bords de la couche transférée.

### Résumé de l'invention

Un mode de réalisation prévoit un procédé de transfert d'une couche depuis un substrat source vers un substrat destination, comprenant les étapes suivantes :
a) disposer un disque de masquage sur une partie centrale d'une surface de collage de ladite couche et/ou du substrat destination ;
b) mettre en oeuvre une gravure ionique de façon à former une marche en vis à vis d'une partie périphérique, non couverte par le disque de masquage, de la surface de collage de ladite couche et/ou du substrat destination ;
c) retirer le disque de masquage ;
d) activer la surface de collage de ladite couche et la surface de collage du substrat destination par gravure ionique ou dépôt ionique d'un matériau de collage ; et
e) après l'étape d), mettre en contact la surface de collage de ladite couche avec la surface de collage du substrat destination,

dans lequel les étapes b) et d) sont mises en oeuvre successivement dans une même chambre de traitement ionique; et
dans lequel les étapes d) et e) sont mises en oeuvre sous vide, sans rupture de vide entre les deux étapes.

Selon un mode de réalisation, le substrat destination et/ ou le substrat source a des bords biseautés sur une première largeur.

Selon un mode de réalisation, après l'étape b), la marche s'étend, à partir du bord de ladite couche et/ou du bord du substrat destination sur une largeur supérieure ou égale à la première largeur.

Selon un mode de réalisation, le disque a un diamètre inférieur au diamètre du substrat source et/ou au diamètre du substrat destination.

Selon un mode de réalisation, le procédé comprend, après l'étape e), une étape f) de retrait du substrat source.

Selon un mode de réalisation, l'étape f) comprend une étape de recuit conduisant à fracturer l'assemblage obtenu à l'issue de l'étape e), dans le plan d'une couche enterrée implantée séparant ladite couche du substrat source.

Selon un mode de réalisation, ladite couche est une couche semiconductrice.

Selon un mode de réalisation, le procédé comprend, après l'étape f), une étape d'épitaxie sur et en contact avec la face de ladite couche opposée au substrat destination.

Selon un mode de réalisation, après l'étape b), la marche s'étend sur une profondeur, à partir de la surface de collage de ladite couche et/ou la surface de collage du substrat destination, supérieure à 700 nm.

Selon un mode de réalisation, l'étape d) consiste en le dépôt d'une couche de collage sur la surface de collage de ladite couche et/ou sur la surface du substrat destination.

Selon un mode de réalisation, la couche de collage a une épaisseur comprise entre 0,2 nm et 100 nm, par exemple comprise entre 1 nm et 20 nm.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

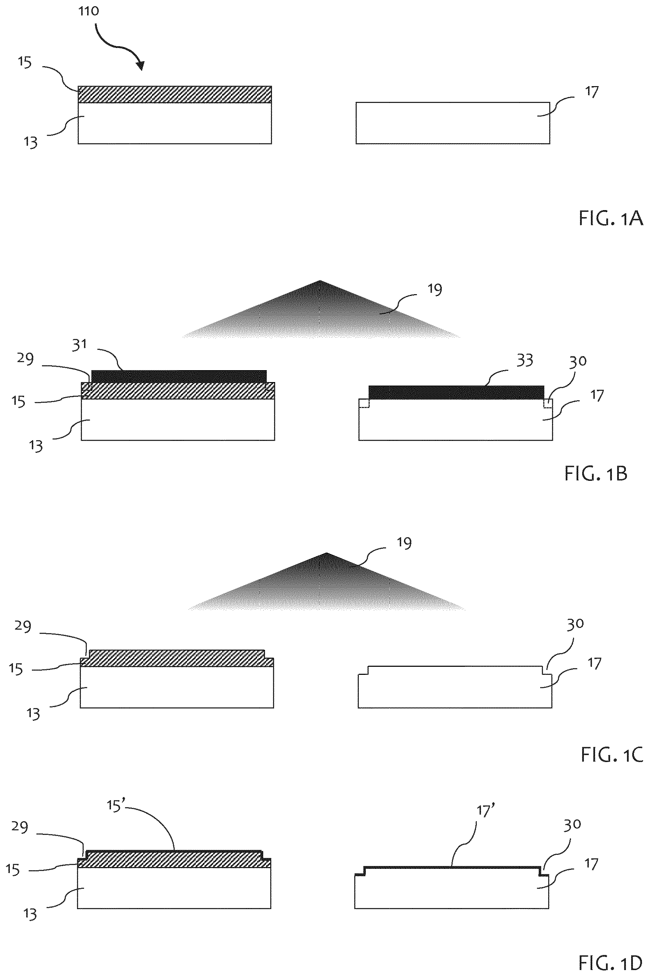

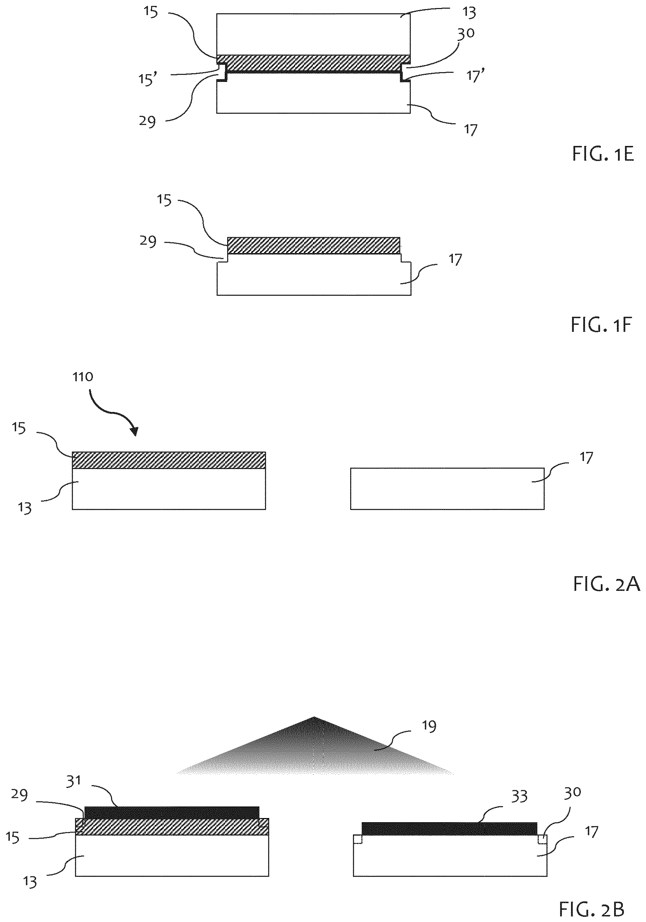

la figure 1A, la figure 1B, la figure 1C, la figure 1D, la figure 1E et la figure 1F sont des vues en coupe, illustrant de façon partielle et schématique, des étapes successives d'un exemple de procédé de transfert d'une couche semiconductrice depuis un substrat source vers un substrat destination selon un premier mode de réalisation ; et

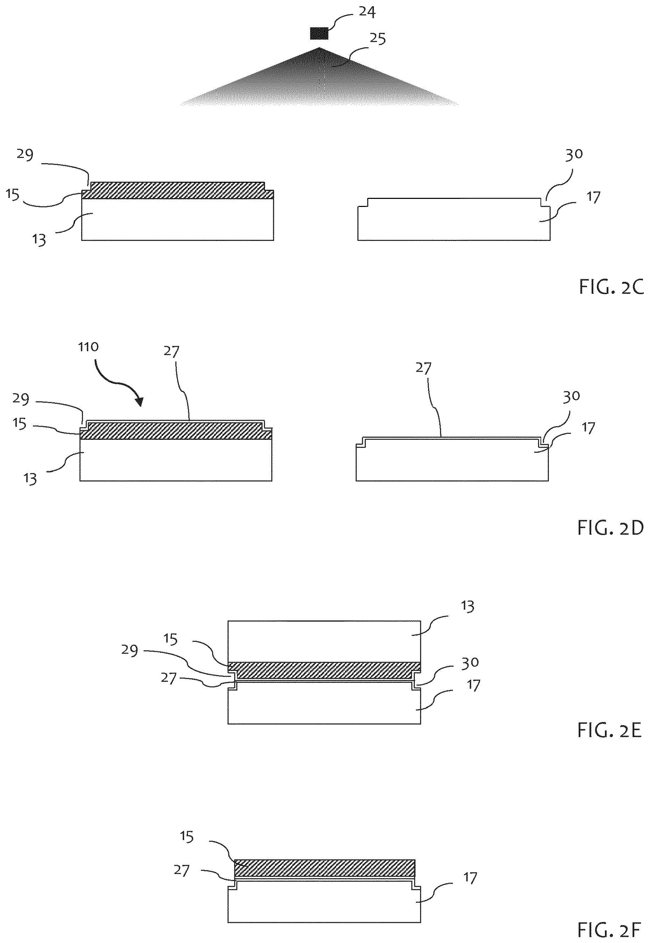

la figure 2A, la figure 2B, la figure 2C, la figure 2D, la figure 2E et la figure 2F sont des vues en coupe, illustrant de façon partielle et schématique, des étapes successives d'un exemple de procédé de transfert d'une couche semiconductrice depuis un substrat source vers un substrat destination selon un deuxième mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les procédés de fabrication de composants microélectroniques à partir des couches semiconductrices transférées n'ont pas été détaillés, les procédés de transfert décrits étant compatibles avec tous ou la plupart des procédés usuels de fabrication des composants microélectroniques.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

La figure 1A, la figure 1B, la figure 1C, la figure 1D, la figure 1E et la figure 1F sont des vues en coupe, illustrant de façon partielle et schématique, des étapes successives d'un exemple de procédé de transfert d'une couche semiconductrice depuis un substrat source vers un substrat destination selon un premier mode de réalisation.

La figure 1A représente, en partie gauche, une structure 110 comportant un substrat source 13 et une couche semiconductrice à transférer 15, et, en partie droite, un substrat destination 17.

La couche semiconductrice à transférer 15 est disposée sur la face supérieure du substrat 13 et, par exemple en contact avec celle-ci. La couche semiconductrice 15 s'étend par exemple de façon continue et avec une épaisseur sensiblement uniforme sur toute la surface supérieure du substrat 13. La couche semiconductrice 15 est par exemple une couche monocristalline. A titre d'exemple, la couche semiconductrice 15 est une couche de carbure de silicium (SiC), par exemple monocristallin, par exemple de type 4H-SiC. A titre de variante, la couche semiconductrice 15 est en germanium (Ge), par exemple monocristallin. Les modes de réalisation décrits ne se limitent pas à ces exemples particuliers.

Le substrat source 13 est par exemple en un matériau semiconducteur. A titre d'exemple, le substrat source 13 est en le même matériau que la couche semiconductrice 15. Les modes de réalisation décrits ne se limitent toutefois pas à ce cas particulier.

La couche à transférer 15 a, par exemple, une épaisseur comprise entre 100 nm et 10 µm, par exemple entre 300 nm et 2 µm.

Le substrat source 13 présente par exemple une épaisseur comprise entre 100 µm et 1 mm, par exemple entre 250 µm et 800 µm, par exemple de l'ordre de 350 µm.

Le substrat destination 17 peut être en un matériau semiconducteur ou en un matériau diélectrique. Le substrat destination 17 est par exemple une plaquette (wafer) semiconductrice, par exemple en silicium ou en carbure de silicium polycristallin, par exemple de type 3C-SiC.

A titre d'exemple, le substrat destination 17 et le substrat source 13 ont sensiblement la même forme et les mêmes dimensions en vue de dessus. A titre d'exemple, le substrat destination 17 et le substrat source 13 sont tous les deux, en vue de dessus, de forme circulaire et ont, par exemple le même diamètre.

Pour limiter les risques de casse, le substrat destination 17 et/ou le substrat source 13 présentent de préférence des bords biseautés ou arrondis et une zone de tombé de bords, par exemple sur une bande annulaire périphérique de largeur comprise entre 0,1 mm et 5 mm, par exemple entre 0,2 mm et 3 mm. Autrement dit, le substrat destination 17 et/ou le substrat source 13 présentent, à leur périphérie, une épaisseur décroissante en s'éloignant du centre du substrat, par exemple sur une bande annulaire périphérique de largeur comprise entre 0,1 mm et 5 mm, par exemple entre 0,2 et 3 mm.

Lors du collage de la couche à transférer 15 sur le substrat destination 17, la couche à transférer 15 est mise en contact, par sa face supérieure dans l'orientation de la figure 1A, sur la face supérieure du substrat destination 17.

En pratique, et tout particulièrement dans le cas où le substrat destination 17 et/ou le substrat source 13 présentent des bords biseautés, on observe que le collage de la couche 15 sur le substrat destination 17 est incomplet en périphérie de l'assemblage. En effet, lors du collage de la couche 15 sur le substrat 17, alors que la couche 15 et le substrat 17 sont bien contactés au centre de l'assemblage, ils ne le sont pas ou seulement partiellement en bordure de l'assemblage, notamment en raison du biseau périphérique des substrats, et/ou d'éventuels défauts de planéité des substrats.

A l'issue d'une étape de retrait du substrat source 13, les parties périphériques de la couche 15 non collées ou mal collées au substrat destination 17 se détachent. Ainsi, une bande annulaire périphérique du substrat destination 17 n'est pas recouverte ou seulement partiellement recouverte par la couche 15.

En l'absence de précautions particulières, à l'issue du transfert, les bords de la couche 15 en périphérie de l'assemblage sont irréguliers. Ceci est dû au fait que la limite de collage entre la couche 15 et le substrat destination 17 est irrégulière. Cette irrégularité des bords de la couche 15 peut engendrer des défauts susceptibles de se propager vers le centre de la couche 15 lors d'étapes ultérieures de fabrication de composants microélectroniques, par exemple lors d'une étape d'épitaxie à partir de la face supérieure de la couche 15. Les défauts sont en particulier susceptibles de se propager dans la couche épitaxiée sur la couche 15.

On cherche ici à améliorer la régularité ou netteté des bords de la couche 15 à l'issue du transfert.

La figure 1B illustre une étape de gravure d'une marche 29 sur la périphérie de la face supérieure, appelée surface de collage de la couche 15, et d'une marche 30, sur la périphérie de la face supérieure, appelée surface de collage du substrat destination 17.

La marche 29 s'étend, à partir de la face supérieure de la couche 15, par exemple dans une partie de la couche 15. En variante, la marche 29 s'étend, à partir de la face supérieure de la couche 15 dans la couche 13 et, par exemple, dans une partie du substrat 13.

Les marches 29 et 30 sont réalisées par un procédé de gravure ou abrasion ionique consistant à envoyer sur les zones à graver un faisceau d'ions 19 ou d'atomes, par exemple neutres. Cette étape est réalisée sous vide, c'est-à-dire à pression inférieure à la pression atmosphérique, par exemple sous-ultravide, par exemple sous une pression inférieure à 10⁻⁷ mbar, par exemple inférieure à 10⁻⁸ mbar.

Lors de l'étape de gravure, seules les parties libres des faces supérieures du substrat destination 17 et de la couche 15, c'est-à-dire les parties de la face supérieure de la couche 15 et du substrat destination 17 qui ne sont pas recouvertes par un masque sont gravées.

Dans l'exemple, de la figure 1B, afin de ne former une marche 29 que sur la périphérie de la surface de collage de la couche 15 et une marche 30 que sur la périphérie de la surface de collage du substrat destination 17, les parties centrales des surfaces de collage sont chacune recouvertes par un disque de masquage. Ainsi, lors de l'étape de gravure, un disque de masquage 31 recouvre une partie centrale de la surface de collage de la couche 15 et un disque de masquage 33 recouvre une partie centrale de la surface de collage du substrat destination 17.

A titre d'exemple, en projection verticale, le centre du disque de masquage 31 coïncide avec le centre du substrat source 13, et le centre du disque de masque 33 coïncide avec le centre du substrat destination 17. A titre d'exemple, le diamètre du disque de masquage 31 est inférieur au diamètre du substrat source 13 et le diamètre du disque de masquage 33 est inférieur au diamètre du substrat destination 17. La différence entre le diamètre du substrat source 13 et le diamètre du disque de masquage 31 est, par exemple comprise entre 0,1 mm et 5 mm, par exemple entre 0,5 mm et 3 mm, par exemple de l'ordre de 1 mm. La différence entre le diamètre du substrat destination 17 et le diamètre du disque de masquage 33 est, par exemple comprise entre 0,1 mm et 5 mm, par exemple entre 0,5 mm et 3 mm, par exemple de l'ordre de 1 mm. A titre d'exemple, les disques de masquage 31 et 33 sont identiques, aux dispersions de fabrication près.

Les disques de masquage 31 et 33 sont, par exemple, métalliques et/ou en un matériau semiconducteur ou isolant. A titre d'exemple, pendant l'étape de gravure des marches 29 et 30, le disque de masquage 31 est disposé sur et en contact avec la face supérieure de la couche semiconductrice 15, et le disque de masquage 33 est disposé sur et en contact avec la face supérieure du substrat destination 17.

Dans l'exemple représenté, la gravure de la marche 29 dans la couche 15 et la gravure de la marche 30 dans le substrat destination 17 sont réalisées simultanément. En variante, la gravure de la marche 29 dans la couche 15 et la gravure de la marche 30 dans le substrat destination 17 sont réalisées successivement.

A titre d'exemple, la marche 29 a une profondeur, à partir de la face supérieure de la couche 15, supérieure à environ 700 nm, par exemple supérieure à environ 1 µm. A titre d'exemple, la marche 30 a une profondeur, à partir de la face supérieure du substrat 17, supérieure à environ 700 nm, par exemple supérieure à environ 1 µm. A titre d'exemple, de par la nature différente de la couche 15 et du substrat 17, la marche 29 et la marche 30 n'ont pas la même profondeur.

A l'issue de cette étape, les disques de masquage 31 et 33 sont retirés.

La figure 1C illustre une étape d'activation des surfaces de collage de la couche 15 et du substrat destination 17.

Le procédé mis en oeuvre lors de cette étape est un procédé de gravure ou abrasion ionique similaire au procédé mis en oeuvre lors de la formation des marches 29 et 30. En particulier, selon un aspect du mode de réalisation des figures 1A à 1F, l'activation des surfaces de collage par gravure ou abrasion ionique est réalisée dans la même chambre de traitement ionique que la gravure des marches 29, 30. L'énergie de gravure et/ou le temps de gravure sont toutefois inférieurs à l'énergie de gravure et/ou au temps de gravure mis en oeuvre lors de la formation des marches 29 et 30 de façon à activer les surfaces exposées sans graver une épaisseur significative de la couche 15 et du substrat 17.

Lors de cette étape, le faisceau d'ions 19 ou d'atomes, par exemple neutres envoyés sur les surfaces à activer permet de retirer, par exemple, les éventuels oxydes présents en surface des faces à activer en laissant des liaisons pendantes qui serviront à former des liaisons covalentes lors de la mise en contact des surfaces activées dans une étape ultérieure. Un tel procédé de collage est généralement appelé collage activé en surface ou SAB (de l'anglais "Surface Activated Bonding"). A titre d'exemple, lors de cette étape, le retrait de matières des surfaces à activer est inférieure à quelques nanomètres, par exemple inférieure à 5 nm. En tout état de cause, l'épaisseur de matière retirée lors de cette étape d'activation est inférieure à l'épaisseur retirée lors de la formation des marches 29 et 30.

A titre d'exemple, lors de l'étape illustrée en figure 1C, le temps d'exposition des surfaces est, par exemple diminué et/ou la puissance du faisceau 19 d'ions est, par exemple diminuée par rapport à l'étape illustrée en figure 1B.

Dans l'exemple représenté, l'activation de la surface de collage de la couche 15 et l'activation de la surface de collage du substrat destination 17 sont réalisées simultanément. L'activation de la surface de collage de la couche 15 et l'activation de la surface de collage du substrat destination 17 sont réalisées successivement sans rupture de vide.

A titre d'exemple, lors de cette étape, toute la surface de la surface de collage du substrat 17 et toute la surface de la surface de collage de la couche 15 sont activées.

La figure 1D illustre la structure 110 et le substrat destination 17 à l'issue de l'étape d'activation des faces supérieures du substrat destination 17 et de la couche 15.

A ce stade, une face 15' correspondant à la surface de collage de la couche 15 qui se prolonge dans la marche 29 et une face 17' correspondant à la surface de collage du substrat destination 17 qui se prolonge dans la marche 30 sont activées au même titre que les parties centrales de la couche 15 et du substrat 17.

La figure 1E illustre une étape de collage de la structure 110 sur le substrat destination 17. Lors de cette étape, la surface de collage 15' de la couche 15 est mise en contact avec la surface de collage 17' du substrat destination 17. De par la géométrie de la structure 110 et du substrat 17, lors de cette étape, seule une zone centrale de la surface de collage de la couche 15, délimitée par la marche 29 est mise en contact d'une zone centrale de la surface de collage du substrat 17, délimitée par la marche 30.

Les liaisons pendantes formées sur la surface de collage de la couche 15 et les liaisons pendantes formées sur la surface de collage du substrat 17 créent, lorsqu'elles sont mises en contact, des liaisons covalentes assurant la fixation de la couche 15 sur le substrat 17. La profondeur des marches 29, 30 étant suffisamment importante, les liaisons pendantes formées en périphérie de la couche 15, dans la marche 29 et les liaisons pendantes formées en périphérie du substrat 15, dans la marche 30, bien qu'elles soient mises en vis-à-vis ne forment pas de liaisons covalentes.

A titre d'exemple, l'étape de collage est réalisée sous une température comprise entre 10 °C et 400 °C, par exemple entre 10 °C et 40 °C, par exemple à température ambiante.

La figure 1F illustre la structure obtenue à l'issue d'une étape de retrait du substrat source 13 de la structure illustrée en figure 1E.

A titre d'exemple, le substrat 13 est en le même matériau semiconducteur que la couche 15, et une couche enterrée (non visible sur les figures) implantée, par exemple par des ions hydrogène (H+), sépare la couche 15 du substrat source 13. A titre d'exemple, la structure 110 est initialement une plaquette (wafer) semiconductrice monocristalline, que l'on vient implanter par sa face supérieure, par exemple par des ions hydrogène, de façon à créer la couche implantée enterrée séparant la couche à transférer 15 du substrat source 13. A titre d'exemple, le retrait du substrat source 13 peut comprendre une étape de recuit thermique conduisant à fracturer la structure 110 dans le plan de la couche implantée enterrée, de façon à permettre de retirer le substrat source 13 et conserver uniquement la couche 15 sur le substrat destination 17.

Plus généralement, le retrait du substrat 13 peut être réalisé par toute autre méthode connue de retrait d'un substrat source lors d'un transfert d'une couche semiconductrice d'un substrat source vers un substrat destination, par exemple par meulage, ou par un procédé de décollement laser (laser lift off).

Lors du retrait du substrat source 13, seule la zone centrale de la couche à transférer 15 située hors du vis-à-vis des marches 29 et 31 reste fixée au substrat destination 17. La partie périphérique du substrat destination 17, située en vis-à-vis des marches 29 et 30 reste en revanche libre, c'est-à-dire non recouverte par la couche 15.

Ainsi, à l'issue du procédé illustré en figures 1A à 1F, la couche transférée 15 présente un bord net et régulier correspondant sensiblement au bord de la marche 29 et/ou 30.

Les étapes d'activation des surfaces de collage (figure 1C) et de collage (figure 1E) sont réalisées sans rupture de vide, par exemple au sein d'un même équipement, comprenant par exemple, une chambre d'activation dans laquelle est mise en oeuvre l'étape de gravure de la figure 1B et l'étape d'activation de la figure 1C, et une chambre de collage dans laquelle est mise en oeuvre l'étape de collage de la figure 1E.

En pratique, lors de l'étape de collage (figure 1E), on cherche à aligner les structures de façon à faire coïncider les zones centrales de la surface de collage de la couche 15, délimitée par la marche 29 et de la surface de collage du substrat 17, délimitée par la marche 30. Toutefois, même si l'alignement n'est pas parfait, la solution proposée permet d'obtenir un bord net de la couche transférée, puisque seules les portions des surfaces de collage mises en contact adhèrent l'une à l'autre.

Dans l'exemple illustré en figure 1B, la gravure de la couche 15 est réalisée à travers un disque de masquage 31 de sorte à former une marche 29 dans la couche 15 et la gravure du substrat destination 17 est réalisée à travers un disque de masquage 33 de sorte à former une marche 30 dans le substrat destination 17. En variante, un disque de masquage peut être prévu uniquement sur la couche 15 ou uniquement sur le substrat destination 17 de façon à former une marche sur une seule des deux surfaces de collage.

La figure 2A, la figure 2B, la figure 2C, la figure 2D, la figure 2E et la figure 2F sont des vues en coupe, illustrant de façon partielle et schématique, des étapes successives d'un exemple de procédé de transfert d'une couche semiconductrice depuis un substrat source vers un substrat destination selon un deuxième mode de réalisation.

Le deuxième mode de réalisation est similaire au premier mode de réalisation illustré en figures 1A à 1F, à la différence près que, dans le deuxième mode de réalisation, l'activation des surfaces de collage est réalisée par dépôt d'une fine couche d'un matériau de collage apportant des liaisons pendantes permettant ensuite de former des liaisons covalentes lors de la mise en contact des surfaces activées. Les éléments communs avec le procédé des figures 1A à 1F ne seront pas détaillés à nouveau ci-après. Seules les différences avec le procédé des figures 1A à 1F seront mises en exergue.

La figure 2A illustre, de façon similaire à la figure 1A, en partie gauche, la structure 110 comprenant le substrat source 13 et la couche semiconductrice à transférer 15, et, en partie droite, le substrat destination 17.

La figure 2B illustre, de façon similaire à la figure 1B, une étape de gravure de la marche 30, sur la périphérie de la face supérieure du substrat destination 17 et de la marche 29 sur la périphérie de la face supérieure de la couche 15.

La figure 2C illustre une étape d'activation de la surface de collage, de la couche 15 et de la surface de collage, du substrat destination 17.

Cette étape d'activation consiste en le dépôt d'une fine couche d'activation, aussi appelée couche de collage, sur les surfaces à activer. Cela permet de créer des liaisons pendantes qui serviront à former des liaisons covalentes lors de la mise en contact des couches activées dans une étape ultérieure. Cette technique de collage, est appelée collage par diffusion atomique ou ADB (de l'anglais "Atomic Diffusion Bonding").

A titre d'exemple, lors de cette étape, un faisceau d'ions ou d'atomes, par exemple de gaz neutre, par exemple d'argon, bombarde une cible 24 en un matériau dont les atomes 25 se détachent et se déposent uniformément en une fine couche sur la ou les surfaces à activer. A titre d'exemple, la cible est métallique, par exemple, en tungstène ou en titane. En variante, la cible 24 est en un matériau semiconducteur, par exemple, en silicium, en germanium, etc.

Cette étape est réalisée sous vide, c'est-à-dire inférieure à la pression atmosphérique, par exemple sous-ultravide, par exemple sous une pression inférieure à 10⁻⁷ mbar, par exemple inférieure à 10⁻⁸ mbar.

Dans le mode de réalisation des figures 2A à 2F, l'activation des surfaces de collage par pulvérisation d'un matériau de collage est réalisée dans la même chambre de traitement ionique que la gravure des marches 29, 30.

Dans l'exemple représenté, l'activation de la surface de collage de la couche 15 et l'activation de la surface de collage du substrat destination 17 sont réalisées simultanément. A titre de variante, l'activation de la surface de collage de la couche 15 et l'activation de la surface de collage du substrat destination 17 sont réalisées successivement sans rupture de vide.

La figure 2D illustre la structure 110 et le substrat destination 17 à l'issue de l'étape d'activation des surfaces de collage du substrat destination 17 et de la couche 15.

A ce stade, la surface de collage de la couche 15 et la surface de collage du substrat destination 17 sont activées, c'est à dire surmontées par une couche 27 en le matériau de la cible 24. A titre d'exemple, les couches 27 ont chacune une épaisseur supérieure à 0,2 nm, par exemple inférieure à 100 nm. A titre d'exemple, la ou les couches 27 ont une épaisseur comprise entre 1 nm et 20 nm. Dans ce mode de réalisation, la couche 27 se prolonge dans la marche 29 et dans la marche 30, ces zones sont donc activées au même titre que les parties centrales de la couche 15 et du substrat 17.

La figure 2E illustre une étape de collage de la structure 110 de la figure 2D sur le substrat destination 17 de la figure 2C. Lors de cette étape, la partie centrale de la surface de collage de la couche 15 délimitée par la marche 29 est mise en contact avec la partie centrale de la surface de collage du substrat destination 17 délimitée par la marche 30. Plus particulièrement, la couche 27 formée sur la couche 15 et la couche 27 formée sur le substrat destination 17 sont mises en contact. De par la géométrie de la structure 110 et du substrat 17, lors de cette étape, seule une zone centrale de la surface de collage de la couche 15, délimitée par la marche 29 est mise en contact d'une zone centrale de la surface de collage du substrat 17, délimitée par la marche 30.

Les liaisons pendantes de la couche 27 déposée sur la couche 15 et celles de la couche 27 déposée sur le substrat 17 créent, lorsqu'elles sont mises en contact, des liaisons covalentes assurant la fixation de la couche 15 sur le substrat 17. La profondeur des marches 29, 30 étant suffisamment importante, les liaisons pendantes formées en périphérie de la couche 15, dans la marche 29 et les liaisons pendantes formées en périphérie du substrat 15, dans la marche 30, bien qu'elles soient mises en vis-à-vis ne forment pas de liaisons covalentes.

A titre d'exemple, l'étape de collage est réalisée sous une température comprise entre 10 °C et 400 °C, par exemple entre 10 °C et 40 °C, par exemple à température ambiante.

A titre d'exemple, la résistivité d'interface entre la couche 15 et le substrat destination 17 est inférieure à 10⁻³ Ω.cm⁻², par exemple, inférieure à 10⁻⁵ Ω.cm⁻². Ceci permet au collage d'être électriquement transparent.

La figure 2F illustre la structure obtenue à l'issue d'une étape de retrait du substrat source 13 de la structure illustrée en figure 2E.

A titre d'exemple, le substrat 13 est en le même matériau semiconducteur que la couche 15, et une couche enterrée (non visible sur les figures) implantée, par exemple par des ions hydrogène (H+), sépare la couche 15 du substrat source 13. A titre d'exemple, la structure 110 est initialement une plaquette (wafer) semiconductrice monocristalline, que l'on vient implanter par sa face supérieure, par exemple par des ions hydrogène, de façon à créer la couche implantée enterrée séparant la couche à transférer 15 du substrat source 13. A titre d'exemple, le retrait du substrat source 13 peut comprendre une étape de recuit thermique conduisant à fracturer la structure 110 dans le plan de la couche implantée enterrée, de façon à permettre de retirer le substrat source 13 et conserver uniquement la couche 15 sur le substrat destination 17.

Plus généralement, le retrait du substrat 13 peut être réalisé par toute autre méthode connue de retrait d'un substrat source lors d'un transfert d'une couche semiconductrice d'un substrat source vers un substrat destination, par exemple par meulage, ou par un procédé de décollement laser (laser lift off).

Comme précédemment, lors du retrait du substrat source 13, seule la zone centrale de la couche à transférer 15 située hors du vis-à-vis des marches 29 et 30 reste fixée au substrat destination 17. La partie périphérique du substrat destination 17, située en vis à vis des marches 29 et 30 reste en revanche libre, c'est à dire non recouverte par la couche 15.

Ainsi, à l'issue du procédé illustré en figures 2A à 2F, la couche transférée 15 présente un bord net et régulier correspondant sensiblement au bord de la marche 29 et/ou 30.

Les étapes d'activation des surfaces de collage (figure 2C) et de collage (figure 2E) sont réalisées sans rupture de vide, au sein d'un même équipement, comprenant par exemple une chambre d'activation dans laquelle est mise en oeuvre l'étape d'activation de la figure 2C, et une chambre de collage dans laquelle est mise en oeuvre l'étape de collage de la figure 2E.

Dans l'exemple illustré en figure 2B, la gravure de la couche 15 est réalisée à travers un disque de masquage 31 de sorte à former une marche 29 dans la couche 15 et la gravure du substrat destination 17 est réalisée à travers un disque de masquage 33 de sorte à former une marche 30 dans le substrat destination 17. En variante, un disque de masquage peut être prévu uniquement sur la couche 15 ou uniquement sur le substrat destination 17 de façon à former une marche sur une seule des deux surfaces de collage.

En pratique, lors de l'étape de collage, on cherche à aligner les structures de façon à faire coïncider les zones centrales des couches 27 délimitées par les marches 29 et 30. Toutefois, même si l'alignement n'est pas parfait, la solution proposée permet d'obtenir un bord net de la couche transférée, puisque seules les portions des couches 27 mises en contact adhèrent l'une à l'autre.

Un avantage du procédé des figures 1A à 1F et des figures 2A à 2F est que la gravure des marches 29 et/ou 30 permet d'améliorer la netteté de la limite entre la zone centrale collée et la zone périphérique non collée de la couche 15.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples de matériaux et de dimensions mentionnés dans la présente description.

De plus, les modes de réalisations ont été décrits pour des substrats source et destination circulaires toutefois ils peuvent avoir une forme différente.

Encore, bien que les procédés proposés soit avantageux pour le transfert d'une couche semiconductrice d'un substrat source vers un substrat destination, ils peuvent également être mis en oeuvre pour transférer des couches de natures différentes comme des couches métalliques ou des couches diélectriques d'un substrat source vers un substrat destination.

Enfin, la mise en oeuvre pratique des modes de réalisation et variantes décrits est à la portée de la personne du métier à partir des indications fonctionnelles données ci-dessus.

## Revendications

1. Procédé de transfert d'une couche (15) depuis un substrat source (13) vers un substrat destination (17), comprenant les étapes suivantes :
a) disposer un disque de masquage (31, 33) sur une partie centrale d'une surface de collage de ladite couche (15) et/ou du substrat destination (17) ;
b) mettre en oeuvre une gravure ionique de façon à former une marche (29, 30) en vis à vis d'une partie périphérique, non couverte par le disque de masquage (31, 33), de la surface de collage de ladite couche (15) et/ou du substrat destination (17) ;
c) retirer le disque de masquage (31, 33) ;
d) activer la surface de collage de ladite couche (15) et la surface de collage du substrat destination (17) par gravure ionique ou dépôt ionique d'un matériau de collage ; et
e) après l'étape d), mettre en contact la surface de collage de ladite couche (15) avec la surface de collage du substrat destination (17),
dans lequel les étapes b) et d) sont mises en oeuvre successivement dans une même chambre de traitement ionique; et
dans lequel les étapes d) et e) sont mises en oeuvre sous vide, sans rupture de vide entre les deux étapes.

2. Procédé selon la revendication 1, dans lequel le substrat destination (17) et/ ou le substrat source (13) a des bords biseautés sur une première largeur.

3. Procédé selon la revendication 2, dans lequel, après l'étape b), la marche (29, 30) s'étend, à partir du bord de ladite couche (15) et/ou du bord du substrat destination (17) sur une largeur supérieure ou égale à la première largeur.

4. Procédé selon l'une quelconque des revendications 1 à 3, dans lequel le disque (31, 33) a un diamètre inférieur au diamètre du substrat source (13) et/ou au diamètre du substrat destination (17).

5. Procédé selon l'une quelconque des revendications 1 à 4, comportant, après l'étape e), une étape f) de retrait du substrat source (13).

6. Procédé selon la revendication 5, dans lequel l'étape f) comprend une étape de recuit conduisant à fracturer l'assemblage obtenu à l'issue de l'étape e), dans le plan d'une couche enterrée implantée séparant ladite couche (15) du substrat source (13).

7. Procédé selon l'une quelconque des revendications 1 à 6, dans lequel ladite couche (15) est une couche semiconductrice.

8. Procédé selon la revendication 7, comprenant, après l'étape f), une étape d'épitaxie sur et en contact avec la face de ladite couche (15) opposée au substrat destination (17).

9. Procédé selon l'un quelconque des revendications 1 à 8, dans lequel, après l'étape b), la marche (31, 33) s'étend sur une profondeur, à partir de la surface de collage de ladite couche (15) et/ou la surface de collage du substrat destination (17), supérieure à 700 nm.

10. Procédé selon l'une quelconque des revendications 1 à 9, dans lequel l'étape d) consiste en le dépôt d'une couche de collage (27) sur la surface de collage de ladite couche (15) et/ou sur la surface du substrat destination (17).

11. Procédé selon la revendication 10, dans lequel la couche de collage (27) a une épaisseur comprise entre 0,2 nm et 100 nm, par exemple comprise entre 1 nm et 20 nm.

## Patentansprüche

1. Ein Verfahren zum Übertragen einer Schicht (15) von einem Quellsubstrat (13) auf ein Zielsubstrat (17), das die folgenden Schritte aufweist:
a) Anordnen einer Maskierungsscheibe (31, 33) auf einem zentralen Abschnitt einer Verbindungsoberfläche der Schicht (15) und/oder des Zielsubstrats (17);
b) Durchführen eines Ionenätzens zum Ausbilden einer Stufe (29, 30) vor einem peripheren Abschnitt, der nicht von der Maskierungsscheibe (31, 33) bedeckt ist, der Verbindungsoberfläche der Schicht (15) und/oder des Zielsubstrats (17);
c) Entfernen der Maskierungsscheibe (31, 33);
d) Aktivieren der Verbindungsoberfläche der Schicht (15) und der Verbindungsoberfläche des Zielsubstrats (17) durch Ionenätzen oder Ionenabscheidung eines Verbindungsmaterials; und
e) nach Schritt d), Inkontaktbringen der Verbindungsoberfläche der Schicht (15) mit der Verbindungsoberfläche des Zielsubstrats (17),
wobei die Schritte b) und d) nacheinander in derselben Ionenbehandlungskammer durchgeführt werden; und
wobei die Schritte d) und e) unter Vakuum und ohne Unterbrechen des Vakuums zwischen den beiden Schritten durchgeführt werden.

2. Das Verfahren nach Anspruch 1, wobei das Zielsubstrat (17) und/oder das Quellsubstrat (13) abgeschrägte Kanten über eine erste Breite aufweist.

3. Das Verfahren nach Anspruch 2, wobei sich nach Schritt b) die Stufe (29, 30) von dem Rand der Schicht (15) und/oder von dem Rand des Zielsubstrats (17) über eine Breite erstreckt, die größer als oder gleich der ersten Breite ist.

4. Das Verfahren nach einem der Ansprüche 1 bis 3, wobei die Scheibe (31, 33) einen Durchmesser aufweist, der kleiner als der Durchmesser des Quellsubstrats (13) und/oder kleiner als der Durchmesser des Zielsubstrats (17) ist.

5. Das Verfahren nach einem der Ansprüche 1 bis 4, aufweisend nach Schritt e) einen Schritt f) des Entfernens des Quellsubstrats (13).

6. Das Verfahren nach Anspruch 5, wobei Schritt f) einen Temperschritt aufweist, der zu einem Brechen der am Ende von Schritt e) erhaltenen Anordnung in der Ebene einer implantierten vergrabenen Schicht führt, die die Schicht (15) von dem Quellsubstrat (13) trennt.

7. Das Verfahren nach einem der Ansprüche 1 bis 6, wobei die Schicht (15) eine Halbleiterschicht ist.

8. Das Verfahren nach Anspruch 7, aufweisend nach Schritt f) einen Schritt des Epitaxiewachstums auf und in Kontakt mit der Oberfläche der Schicht (15), die dem Zielsubstrat (17) gegenüberliegt.

9. Das Verfahren nach einem der Ansprüche 1 bis 8, wobei sich nach Schritt b) die Stufe (31, 33) von der Verbindungsoberfläche der Schicht (15) und/oder der Verbindungsoberfläche des Zielsubstrats (17) bis zu einer Tiefe erstreckt, die größer als 700 nm ist.

10. Das Verfahren nach einem der Ansprüche 1 bis 9, wobei Schritt d) aus dem Abscheiden einer Verbindungsschicht (27) auf die Verbindungsoberfläche der Schicht (15) und/oder auf die Verbindungsoberfläche des Zielsubstrats (17) besteht.

11. Das Verfahren nach Anspruch 10, wobei die Verbindungsschicht (27) eine Dicke im Bereich von 0,2 nm bis 100 nm, beispielsweise im Bereich von 1 nm bis 20 nm, aufweist.

## Claims

1. Method of transferring a layer (15) from a source substrate (13) to a destination substrate (17), comprising the following steps:
a) arranging a masking disk (31, 33) on a central portion of a bonding surface of said layer (15) and/or of the destination substrate (17);
b) implementing an ion etching to form a step (29, 30) in front of a peripheral portion, not covered with the masking disk (31, 33), of the bonding surface of said layer (15) and/or of the destination substrate (17);
c) removing the masking disk (31, 33);
d) activating the bonding surface of said layer (15) and the bonding surface of the destination substrate (17) by ion etching or ion deposition of a bonding material; and
e) after step d), placing into contact the bonding surface of said layer (15) with the bonding surface of the destination substrate (17),
wherein steps b) and d) are successively implemented in a same ion treatment chamber; and
wherein steps d) and e) are implemented under vacuum, with no rupture of vacuum between the two steps.

2. Method according to claim 1, wherein the destination substrate (17) and/or the source substrate (13) has tapered edges across a first width.

3. Method according to claim 2, wherein, after step b), the step (29, 30) extends, from the edge of said layer (15) and/or from the edge of the destination substrate (17) across a width greater than or equal to the first width.

4. Method according to any of claims 1 to 3, wherein the disk (31, 33) has a diameter smaller than the diameter of the source substrate (13) and/or than the diameter of the destination substrate (17).

5. Method according to any of claims 1 to 4, comprising, after step e), a step f) of removal of the source substrate (13).

6. Method according to claim 5, wherein step f) comprises an anneal step resulting in fracturing the assembly obtained at the end of step e), in the plane of an implanted buried layer separating said layer (15) from the source substrate (13).

7. Method according to any of claims 1 to 6, wherein said layer (15) is a semiconductor layer.

8. Method according to claim 7, comprising, after step f), a step of epitaxy on top of and in contact with the surface of said layer (15) opposite to the destination substrate (17).

9. Method according to any of claims 1 to 8, wherein, after step b), the step (31, 33) extends down to a depth, from the bonding surface of said layer (15) and/or the bonding surface of the destination substrate (17), greater than 700 nm.

10. Method according to any of claims 1 to 9, wherein step d) consists of the deposit of a bonding layer (27) onto the bonding surface of said layer (15) and/or onto the bonding surface of the destination substrate (17).

11. Method according to claim 10, wherein the bonding layer (27) has a thickness in the range from 0.2 nm to 100 nm, for example, in the range from 1 nm to 20 nm.
